# EUROPÄISCHE PATENTSCHRIFT

(11) **EP 2 089 899 B1**
(45) Veröffentlichungstag und Bekanntmachung des Hinweises auf die Patenterteilung: **23.02.2011**
(21) Anmeldenummer: 06819196.4
(22) Anmeldetag: 31.10.2006
(51) Int. Cl.: H01L 21/68, H01L 21/683, H01L 21/00

(54) **VORRICHTUNG ZUM POSITIONIEREN UND/ODER ANPRESSEN EINES FLÄCHIGEN BAUTEILS RELATIV ZU EINEM SUBSTRAT UND VERFAHREN ZUM POSITIONIEREN EINES AUFNAHMEWERKZEUGS RELATIV ZU EINEM SUBSTRAT**
DEVICE FOR POSITIONING AND/OR PRESSING A PLANAR COMPONENT RELATIVE TO A SUBSTRATE AND METHOD FOR POSITIONING A PICKING TOOL RELATIVE TO A SUBSTRATE
DISPOSITIF POUR LE POSITIONNEMENT ET/OU L'APPLICATION PAR PRESSION D'UN COMPOSANT PLAT PAR RAPPORT À UN SUBSTRAT ET PROCÉDÉ POUR LE POSITIONNEMENT D'UN OUTIL DE FIXATION PAR RAPPORT À UN SUBSTRAT

(43) Veröffentlichungstag der Anmeldung: 19.08.2009
(73) Patentinhaber: Kulicke & Soffa Die Bonding GmbH, 8572 Berg TG (CH)
(72) Erfinder: SCHUSTER, Johannes, 78462 Konstanz (DE); EISENRING, Stefan, 8280 Kreuzlingen (CH)
(86) Internationale Anmeldenummer: PCT/EP2006/067970
(87) Internationale Veröffentlichungsnummer: WO 2008/052594

(56) Entgegenhaltungen:
- EP-A2- 0 366 880
- FR-A1- 2 506 195
- JP-A- 3 054 836
- JP-A- 10 022 306
- JP-A- 59 117 231

## Beschreibung

Die Erfindung betrifft eine Vorrichtung zum Positionieren und/oder Anpressen eines flächigen Bauteils relativ zu einem Substrat gemäss dem Oberbegriff von Anspruch 1. Derartige Vorrichtungen können beispielsweise bei Die-Bondern (Pick-und Place-Maschinen) zum Handhaben von Halbleiterchips eingesetzt werden. Dabei werden Halbleiterchips, insbesondere ungehäuste Halbleiterchips auf entsprechende Substrate abgelegt bzw. gebondet.

Die exakte Ausrichtung der Bauteile beim Absetzen spielt dabei eine bedeutende Rolle, sodass spezielle Massnahmen für die Positionierung des Aufnahmewerkzeugs erforderlich sind.

Neben der Positioniergenauigkeit spielt dabei auch immer mehr die Parallelität der Bauteile zum Substrat nach dem Bondprozess eine Rolle. Eine Justierung der Parallelität auf der Maschine im Vorfeld des Fertigungsprozesses ist schwierig, da sehr kleine Winkel gemessen werden müssen. Zudem verändert sich die Situation im realen Bondprozess durch das Auftreten von Materialverformungen oder thermischen Einwirkungen.

Die französische Offenlegungsschrift FR 2 506 195 A1 beschreibt ein Montagewerkzeug, welches ein Gelenk umfasst, das gekrümmte Gleitflächen aufweist, zwischen welchen ein Gasdruck eingestellt werden kann, der höher oder tiefer ist als ein Umgebungsdruck, um damit eine Beweglichkeit des Gelenks freizugeben bzw. zu blockieren.

JP 10 022306 A zeigt einen Bondkopf mit einem drehbar gelagerten Chipgreifer, welcher mittels eines Rückhaltemittels pendelnd am Bondkopf aufgehängt ist.

JP 03 054 836 A und JP 59 117 231 A befassen sich ebenfalls mit Werkzeugen, welche eine Ausgleich von Nicht-Parallelitäten erlauben.

Es ist daher eine Aufgabe der Erfindung, eine Vorrichtung der eingangs genannten Art zu schaffen, mit der eine optimale Parallelität des Aufnahmewerkzeugs zur Substratauflagefläche unter Prozessbedingungen und mit einfachen Mitteln gewährleistet ist. Neben der Parallelität, welche durch Kippbewegungen des Werkzeugs erzielt werden kann, sollen aber gegebenenfalls auch Drehbewegungen des Werkzeugs eingestellt und gehalten werden können, sodass die Vorrichtung vielseitig für unterschiedliche Prozesse eingesetzt werden kann.

Diese Aufgabe wird erfindungsgemäss mit einer Vorrichtung gelöst, welche die Merkmale im Anspruch 1 aufweist. Das Aufnahmewerkzeug ist dabei über wenigstens ein mit Druckluft beaufschlagbares Luftlager direkt oder indirekt an der Werkzeughalterung gelagert, wobei die Lagerposition am Luftlager im drucklosen Zustand unter Vorspannkraft fixierbar ist. Mit Luftlagern können bekanntlich annähernd reibungsfreie Lagerstellen geschaffen werden. Die Vorspannkraft sorgt dafür, dass die Lagerstelle ohne Druckbeaufschlagung arretiert ist. Damit kann auf besonders einfache Weise und unter Prozessbedingungen das Aufnahmewerkzeug beispielsweise der Schräglage eines Substrats angepasst werden, indem das Luftlager beaufschlagt und damit die Einstellung ermöglicht wird. Sobald die Druckluftzufuhr unterbrochen wird, ist die Lagerstelle infolge der durch die Vorspannkraft erzeugten Reibung blockiert. Druckluft steht als Arbeitsmedium beispielsweise bei einem Die-Bonder ohnehin zur Verfügung und lässt sich relativ leicht und gefahrlos handhaben.

Die erfindungsgemässe Vorrichtung eignet sich ersichtlicherweise nicht nur zum Bonden von Halbleiterchips, sondern auch für andere Prozesse wie beispielsweise für das Absetzen von Tapes auf Substrate oder auf bereits verarbeitete Halbleiterchips.

Besonders vorteilhaft ist das Aufnahmewerkzeug an zwei sphärischen, konzentrischen Kippluftlagern gelagert, wobei an beiden Seiten einer der Werkzeughalterung zugeordneten, sphärischen Lagerplatte mit gleichsinnig gekrümmten Kipplagerflächen je ein erster und ein zweiter Kipplagerkörper mit je einer korrespondierenden Kippgegenlagerfläche angeordnet ist, wobei die beiden Kipplagerkörper unter Vorspannkraft gegeneinander bzw. gegen die Lagerplatte pressbar sind. Bei der Verwendung von zwei Kippluftlagern lässt sich eine Lagerstelle erzeugen, bei der sich die gegeneinander gelagerten Teile bei aktivierten Luftlagern überhaupt nicht mehr berühren. Bei deaktivierten Luftlagern steht jedoch eine grosse Oberfläche der aneinander liegenden Teile zur Verfügung, womit eine sichere Arretierung gewährleistet ist. Die sphärische Ausbildung der Kippluftlager ermöglicht ein Kippen in alle Richtungen um einen bestimmten Mittelpunkt. Selbstverständlich wäre es in bestimmten Fällen auch denkbar, die Luftlager als ebene Luftlager auszubilden, sodass lediglich eine Bewegung in XY-Richtung möglich wäre.

Das Drehzentrum der beiden sphärischen Kippluftlager liegt vorteilhaft in der Aufnahmeebene des Aufnahmewerkzeugs und vorzugsweise auf dem geometrischen Mittelpunkt der Aufnahmefläche des Aufnahmewerkzeugs. Durch diese zentrische Auslegung relativ zur Bondwerkzeugachse und zur Aufnahmefläche wird einerseits eine hohe Stabilität unter Prozesskräften erreicht und andererseits sichergestellt, dass sich Kippbewegungen in erster Ordnung nicht auf die XY-Lage des zu verarbeitenden Bauteils auswirken.

Eine optimale Bewegungsmöglichkeit ergibt sich, wenn die Lagerplatte eine zentrale Öffnung aufweist und wenn einer der beiden Kipplagerkörper eine die Öffnung durchdringende Führungsspindel aufweist, an welcher der benachbarte Kipplagerkörper unter Vorspannung gelagert ist, wobei der Innendurchmesser der zentralen Öffnung der Lagerplatte und der Aussendurchmesser der Führungsspindel so dimensioniert sind, dass das Aufnahmewerkzeug in alle Richtungen um ein begrenztes Mass kippbar ist. Die Durchmesserdifferenz und allenfalls die Länge der Öffnung definieren dabei ersichtlicherweise den maximal möglichen Ausschlag. Es wäre aber auch denkbar, die Öffnung im Querschnitt so auszubilden, dass ein Kippen nur in bestimmte Richtungen möglich ist.

Für die Aktivierung der Kippluftlager sind vorzugsweise um die zentrale Öffnung auf beiden Lagerflächen der sphärischen Lagerplatte an der Oberfläche verlaufende Luftkanäle angeordnet, welche an eine Druckluftquelle anschliessbar sind. Damit wird erreicht, dass bei Aktivierung des Luftlagers sich ein gleichmässiger Luftspalt einstellt und dabei die Vorspannkraft kompensiert wird.

Die Führungsspindel kann ausserdem eine Hohlspindel sein, durch welche ein Luftkanal zum Beaufschlagen des Aufnahmewerkzeugs optional mit einem Unterdruck oder mit einem Überdruck geführt ist. Die Bauteile werden in der Regel am Aufnahmewerkzeug mit einem Unterdruck fixiert, wobei allerdings auch elektromagnetische oder mechanische Haltemittel denkbar sind. Das Absetzen der Bauteile kann fallweise durch Überdruck unterstützt werden.

Zum Vorspannen der beiden Gelenklagerkörper gegeneinander bzw. gegen die Lagerplatte ist an der Führungsspindel vorzugsweise ein Federelement wie z.B. eine Schraubendruckfeder oder eine Tellerfeder gelagert. Die Vorspannkraft könnte aber ganz generell auch mit anderen Vorspannmitteln erzeugt werden, insbesondere auch mit pneumatischen, hydraulischen, permanentmagnetischen oder mit elektromagnetischen Mitteln.

Als besonders vorteilhaft für die Arretierungsfunktion der Lager hat es sich erwiesen, wenn sich eine stets gleich bleibende nominelle Vorspannung der Lager bei Bedarf auf einfache Weise erhöhen lässt. Dies kann beispielsweise dadurch erreicht werden, dass zwei unterschiedliche jedoch kumulativ in die gleiche Richtung wirkende Vorspannmittel eingesetzt werden, von denen eines steuerbar ist. So könnte beispielsweise neben einem rein mechanischen Federelement eine steuerbare Gasdruckfeder eingesetzt werden, mit der sich bei deaktivierten Luftlagern die Haftreibung zwischen den Kipplagerkörpern und der Lagerplatte erhöhen lässt während die Aktivierung der Luftlager ausschliesslich unter Beaufschlagung der nominellen Vorspannkraft durch die Feder erfolgt. Ersichtlicherweise kann die Federvorspannung maximal nur so hoch sein, dass sie die Aktivierung der Luftlager gerade noch erlaubt. Bei gewissen Prozessen kann jedoch die Federvorspannung zum Fixieren des Lagers ungenügend sein. Durch den Einsatz eines steuerbaren zusätzlichen Vorspannmittels können dagegen sehr hohe Anpresskräfte erzielt werden.

Um ein unbeabsichtigtes Verdrehen des Aufnahmewerkzeugs um dessen Achse bzw. der Kipplagerkörper um die Spindelachse bei aktivierten Kippluftlagern zu verhindern, ist zwischen wenigstens einem Kipplagerkörper und der Werkzeughalterung oder der Lagerplatte vorteilhaft eine Verdrehsicherung angeordnet. Die Verdrehsicherung muss dabei ersichtlicherweise so ausgebildet sein, dass sie die Funktion der Luftlager nicht behindert und den zwischen aktiviertem und deaktiviertem Luftlager entstehenden Hub überbrückt und Kippbewegungen bei aktivierten Luftlagern erlaubt. Eine solche Verdrehsicherung kann beispielsweise als Blattfeder ausgeführt sein, die, so ausgelegt ist, dass die Rückstellkraft von unerwünschten Rotationsauslenkungen erheblich höher als die Rückstellkräfte von Kippauslenkungen ist.

Die Vorrichtung kann weiter dadurch verbessert werden, dass an einem der beiden Kipplagerkörper ein Rotationsluftlager angeordnet ist, das eine dem betreffenden Kipplagerkörper zugehörige Rotationslagerfläche und eine an einem Rotationslagerkörper angeordnete Rotationsgegenlagerfläche aufweist. Der Rotationslagerkörper ist unter Vorspannung an der Führungsspindel des gegenüberliegenden Kipplagerkörpers gelagert. Durch Beaufschlagung des Rotationsluftlagers und beider oder allein des gegenüberliegenden Kippluftlagers mit Druckluft ist das Aufnahmewerkzeug frei um seine Längsmittelachse drehbar. Auf diese Weise erhält das Aufnahmewerkzeug einen weiteren Freiheitsgrad durch Drehen um seine Längsmittelachse. In bestimmten Fällen könnte ersichtlicherweise ausschliesslich ein Rotationsluftlager eingesetzt werden, ohne dass dieses zwingend mit einem Kippluftlager kombiniert werden muss. Wenn das Rotationsluftlager in Kombination mit dem gegenüberliegenden sphärischen Luftlager eingesetzt wird, wird allein die freie Drehung um die Längsmittelachse ermöglicht, ohne dass das Aufnahmewerkzeug Kippfreiheitsgrade erhält. Die Rotationsfunktionalität dient primär zum definierten Drehen der Bauteile im produktiven Maschinenbetrieb, während die Kippfunktionalität eher der Ausrichtung des Werkzeugs im Vorfeld eines Arbeitsprozesses dient. So ist es beispielsweise denkbar, dass Bauteile in alternierenden Drehlagen auf das Substrat abgesetzt werden müssen, was sich mit der Vorrichtung optimal lösen lässt. Bei einer geforderten sehr hohen Winkelgenauigkeit können Fehlwinkel zwischen Substrat und Bauteil durch eine Bildverarbeitung ermittelt und durch die Rotationsfunktionalität kompensiert werden.

Nach einer allfälligen Rotation bzw. Winkelkorrektur und unmittelbar vor dem Absetzen eines Bauteils ist es zweckmässig, das Rotationslager zu blockieren. Damit wird sichergestellt, dass ein beim Absetzprozess auf das Werkzeug einwirkende Drehmoment nicht vom Motor kompensiert werden muss, wodurch der Drehantrieb kleiner und damit leichter dimensioniert werden kann. Für die Winkelausrichtung des nächsten Bauteils müssen die Rotationslager wiederum gelöst werden.

Für die Positionierung des Aufnahmewerkzeugs in einem bestimmten Drehwinkel kann das Aufnahmewerkzeug über einen elektrischen Rotationsantrieb drehantreibbar sein.

Der Rotationsantrieb kann über dem Rotationslagerkörper lösbar an dem das Rotationsluftlager tragenden Kipplagerkörper befestigt sein. Damit ergibt sich eine kompakte Bauweise, wobei der Rotationsantrieb bei Bedarf auch weggelassen oder ausgetauscht werden kann.

Eine besonders vorteilhafte Funktionalität der Vorrichtung ergibt sich, wenn die beiden sphärischen Kippluftlager an der sphärischen Lagerplatte und das Rotationsluftlager über separate Druckluftleitungen beaufschlagbar sind wodurch der das Rotationsluftlager tragende Kipplagerkörper bei Bedarf an der Lagerplatte arretierbar ist, sodass bei einer Druckbeaufschlagung des Rotationsluftlagers und des Kippluftlagers am gegenüberliegenden Kipplagerkörper das Aufnahmewerkzeug um die Längsmittelachse drehbar ist. Damit ist es möglich, auf einfache Weise zwei getrennte Positionierungen nacheinander vorzunehmen, wobei zunächst bei arretiertem Rotationsluftlager eine bestimmte Kippstellung eingestellt wird. Dabei sind beide Kippluftlager aktiviert. Anschliessend wird eine bestimmte Rotationslage eingestellt in dem dasjenige Kippluftlager blockiert wird, an dem das Rotationsluftlager angeordnet ist.

Die axiale Vorspannung der Kipplagerkörper gegeneinander sowie des Rotationslagerkörpers gegen den einen Kipplagerkörper erfolgt vorzugsweise über das gleiche Vorspannmittel. In bestimmten Fällen, insbesondere wenn unterschiedlich hohe Klemmkräfte erwünscht sind, könnten aber auch separate Federmittel eingesetzt werden.

Normalerweise erfolgt die Positionierung in die Kippstellung durch Anpressen des Aufnahmewerkzeugs auf ein Substrat oder eine beliebige andere Referenzfläche, wobei das Aufnahmewerkzeug selbständig eine bestimmte Position einnimmt. In bestimmten Fällen wäre es aber auch denkbar, dass die Kippposition des Aufnahmewerkzeugs bei gelösten Kippluftlagern und ohne Kontakt zu einer Referenzfläche durch eine Einstellvorrichtung einstellbar ist. Denkbar wäre beispielsweise ein Manipulator der unterschiedliche Bewegungen ausführen kann.

Die Erfindung betrifft auch ein Verfahren zum Positionieren eines Aufnahmewerkzeugs relativ zu einem Substrat oder anderen Referenzdimensionen, wobei das Aufnahmewerkzeug an einer Werkzeughalterung angeordnet und in vorzugsweise mehreren Freiheitsgraden beweglich gelagert ist, insbesondere an einem Die-Bonder. Ein derartiges Verfahren ist gekennzeichnet durch die Merkmale im Anspruch 17. Die Lagerung des Aufnahmewerkzeugs an einem Luftlager und die Positionierung im aktivierten Zustand des Luftlagers ermöglicht eine sehr präzise Anpassung des Aufnahmewerkzeugs an verschiedene Ist-Zustände. Nach erfolgter Positionierung wird der Luftdruck abgebaut und die Lagerstelle arretiert, sodass nachträglich keine Abweichungen mehr von der positionierten Lage möglich sind.

Das Aufnahmewerkzeug kann zum Positionieren um einen Drehpunkt gekippt und/oder um eine Längsmittelachse gedreht werden. Mit diesen Positioniermöglichkeiten können praktisch alle sich bei Arbeitsprozessen ergebenden Positionierungen berücksichtigt werden.

Die Positionierung in eine Kippstellung erfolgt besonders vorteilhaft durch Anpressen des Aufnahmewerkzeugs bei aktivierten Luftlagern auf ein Substrat oder auf eine Lehre, wobei das Luftlager im angepressten Zustand deaktiviert wird und wobei die Lagerstelle vor dem Abheben des Aufnahmewerkzeug arretiert wird.

Auf diese Weise müssen keinerlei Winkel gemessen werden, sondern das Aufnahmewerkzeug passt sich stets den tatsächlichen Lage des Substrats oder einer allfälligen Lehre an, insbesondere geschieht dies optional auch unter Prozessbedingungen, die später im normalen Betrieb des Die-Bonders vorliegen. Als Lehre könnten beispielsweise Keile verwendet werden, die zu Positionierzwecken unter das Aufnahmewerkzeug gelegt werden.

Weitere Vorteile und Einzelmerkmale der Erfindung ergeben sich aus der nachfolgenden Beschreibung von Ausführungsbeispielen und aus den Zeichnungen. Es zeigen:
- Figur 1: eine teilweise geschnittene Seitendarstellung einer ersten Ausführungsform der Erfindung,
- Figur 2a: die Vorrichtung gemäss Figur 1 mit aktivierten Luftla- gern,
- Figur 2b: die Vorrichtung gemäss Figur 1 beim Positionieren des Aufnahmewerkzeugs,
- Figur 2c: die Vorrichtung gemäss Figur 1 mit deaktivierten Luft- lagern nach der Positionierung,
- Figur 3: eine geschnittene Seitendarstellung einer zweiten Aus- führungsform der erfindungsgemässen Vorrichtung mit zu- sätzlichem Rotationsluftlager, und
- Figur 4: die Vorrichtung gemäss Figur 3 bei aktiviertem Rotati- onsluftlager.

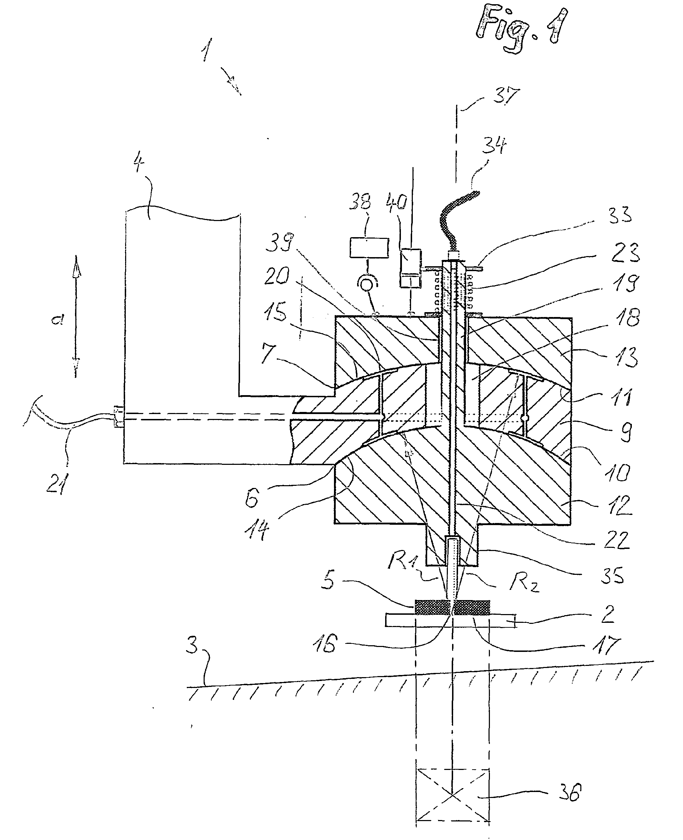

Gemäss Figur 1 besteht die allgemein mit 1 bezeichnete Vorrichtung aus einer Werkzeughalterung 4, die beispielsweise an einem nicht dargestellten Schlitten entlang verschiedener horizontaler Achsen bewegt werden kann. Die Werkzeughalterung ist auch in Pfeilrichtung a relativ zu einem Substrat 3 verstellbar. Unter der Bezeichnung Substrat wird nachfolgend jegliche Unterlage verstanden, auf welche ein Bauteil 2 abgesetzt werden muss oder zu welcher dieses Bauteil eine bestimmte Parallelität einhalten muss. Das Substrat kann somit selbst wiederum aus Bauteilen bestehen.

An der Werkzeughalterung 4 ist ein Aufnahmewerkzeug 5 gelagert, mit dessen Hilfe das Bauteil 2 von einer Vorratsstation aufgenommen und über das Substrat 3 transportiert und dort abgelegt werden kann. Das Aufnahmewerkzeug verfügt beispielsweise über eine rechteckige Aufnahmefläche 36, wie sie in der Umklappung durch die strichpunktierten Linien angedeutet ist. Die Fixierung des Bauteils 2 in der Aufnahmeebene 17 bzw. an der Aufnahmefläche 36 erfolgt hier durch Unterdruck, der über einen Luftkanal 22 angelegt wird. Das eigentliche Aufnahmewerkzeug 5 kann mit Hilfe einer Werkzeugkupplung 35 befestigt werden, welche das Einsetzen unterschiedlicher Werkzeuge erlaubt.

Die Lagerung des Aufnahmewerkzeugs 5 erfolgt über ein erstes sphärisches Kippluftlager 6 und ein zweites sphärisches Kippluftlager 7. Zu diesem Zweck ist eine sphärische Lagerplatte 9 vorgesehen, die eine erste Kipplagerfläche 10 und eine zweite Kipplagerfläche 11 aufweist. Diese Kipplagerflächen sind konzentrisch um einen gemeinsamen Mittelpunkt 16 angeordnet, der sich vorzugsweise in der Aufnahmeebene 17 befindet. Die Kipplagerflächen haben dabei die Radien R1 und R2.

Unter der Lagerplatte 9 ist ein erster Kipplagerkörper 12 mit einer ersten Kipplagergegenlagerfläche 14 angeordnet. Letztere ist ebenfalls mit dem Radius R1 gekrümmt. Der erste Kipplagerkörper 12 verfügt über eine Führungsspindel 19, die sich durch eine Öffnung 18 in der Lagerplatte 9 erstreckt. Wie dargestellt, ist der Innendurchmesser dieser Öffnung um einiges grösser als der Aussendurchmesser der Führungsspindel. Der Luftkanal 22 ist bis ans obere Ende der Führungsspindel durchgeführt, wobei eine flexible Zuleitung 34 zu einer hier nicht dargestellten Vakuumquelle oder Druckluftquelle führt. Die Führungsspindel verläuft in einer Längsmittelachse 37, welche durch den Mittelpunkt 16 verläuft.

Über der Lagerplatte 9 ist ein zweiter Kipplagerkörper 13 angeordnet, der über eine zweite Kippgegenlagerfläche 15 verfügt. Diese ist im Radius R2 gekrümmt. Der zweite Kipplagerkörper 13 verfügt ebenfalls über eine Öffnung 39, durch welche die Führungsspindel 19 möglichst spielfrei geführt ist. Der erste Kipplagerkörper 12 und der zweite Kipplagerkörper 13 werden beispielsweise mittels einer Schraubendruckfeder 23 gegeneinander bzw. gegen die Lagerplatte 9 gepresst. Als Anschlag für die Schraubendruckfeder ist beispielsweise ein Spannring 33 an der Führungsspindel 19 befestigt.

In Figur 1 nur symbolisch dargestellt ist ein pneumatisches Vorspannmittel 40, beispielsweise eine steuerbare Gasdruckfeder, deren Zylinder direkt oder indirekt mit der Führungsspindel in Wirkverbindung steht und deren Kolben in die gleiche Richtung eine Vorspannkraft auf den zweiten Kipplagerkörper ausübt, wie die Schraubendruckfeder 23. Dieses zusätzliche Anpressmittel ermöglicht es zusammen mit geeigneten Steuermitteln die Vorspannkraft temporär zu erhöhen. Beim Aktivieren der Kippluftlager muss ersichtlicherweise der steuerbare Druckmittelzylinder entlüftet werden.

Die beiden Kippluftlager werden über ein System aus Luftkanälen und Luftdüsen 20 aktiviert, welche sich gegen die erste Kipplagerfläche 10 bzw. gegen die zweite Kipplagerfläche 11 öffnen und welche vorzugsweise um die zentrale Öffnung 18 herum geführt bzw. verteilt sind. Die Luftkanäle 20 werden über eine Zufuhrleitung 21 mit Druckluft versorgt und zwar über eine hier nicht dargestellte Druckluftsteuerung.

Über dem zweiten Kipplagerkörper 13 ist symbolisch eine Einstellvorrichtung 38 dargestellt, mit deren Hilfe eine Positionierung des Aufnahmewerkzeugs 5 bei aktivierten Luftlagern möglich ist. Diese Einstellvorrichtung ist jedoch optional und wird nur dann benötigt, wenn eine bestimmte Kippstellung ohne Anpressen gegen das Substrat eingestellt werden soll.

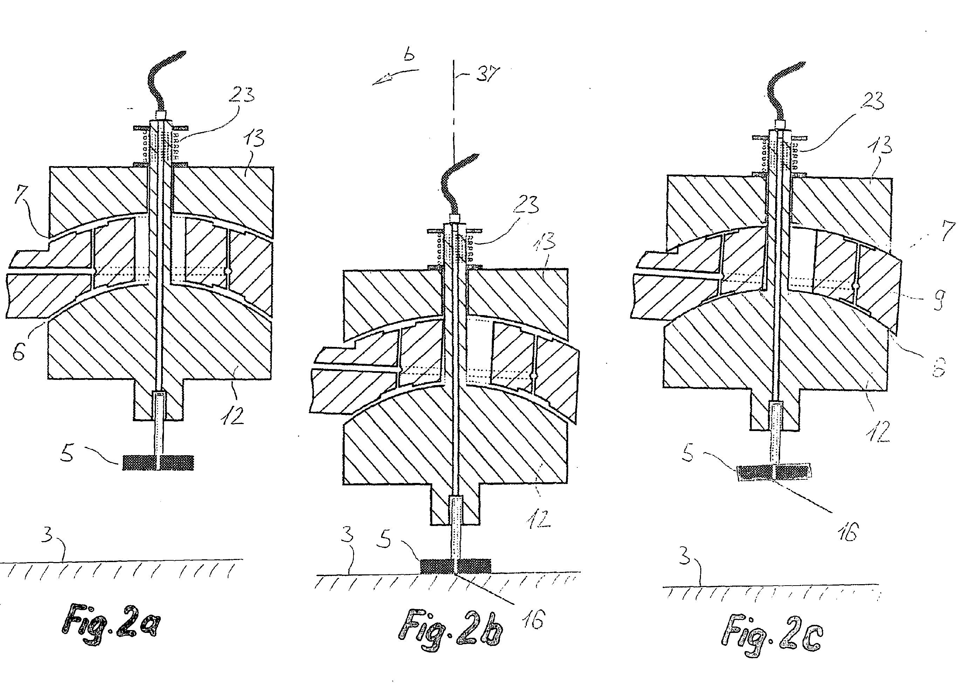

In der in Figur 1 dargestellten Betriebslage sind die beiden sphärischen Kippluftlager deaktiviert, sodass die Schraubendruckfeder 23 für eine kraftschlüssige Verbindung zwischen der Lagerplatte 9 und dem ersten und zweiten Kipplagerkörper 12, 13 sorgt. Das Aufnahmewerkzeug 5 bzw. das Bauteil 2 verlaufen nicht parallel zum Substrat 3. Anhand der Figuren 2a bis 2c wird nachstehend die planparallele Ausrichtung zum Substrat 3 erläutert. Zu diesem Zweck werden gemäss Figur 2a zunächst die beiden Kippluftlager 6, 7 mit Druckluft aktiviert, wobei die beiden Kipplagerkörper 12, 13 gegen die Vorspannkraft der Schraubendruckfeder 23 auseinander gepresst werden und sich über jeder Kipplagerfläche 10, 11 ein Luftspalt bildet. Damit ist die Arretierung aufgehoben und das Aufnahmewerkzeug 5 kann mit minimalen Kräften um das Zentrum 16 des Kippluftlagers gekippt werden. Alternativ kann das Aufnahmewerkzeug auch zuerst gegen das Substrat gefahren und danach die Aktivierung der Kippluftlager vorgenommen werden. In diesem Betriebszustand wird gemäss Figur 2b das Aufnahmewerkzeug 5 gegen das Substrat 3 gepresst, wobei entsprechend der Schräglage des Substrats die Längsmittelachse 37 in Pfeilrichtung b gekippt wird.

Nachdem das Aufnahmewerkzeug 5 die richtige Positionierung erhalten hat, werden die beiden Kippluftlager 6, 7 gemäss Figur 2c deaktiviert, wobei die Lagerstellen unter Einwirkung der Schraubendruckfeder 23 blockiert werden.

Gemäss einer alternativen Einstellmethode kann das Aufnahmewerkzeug bei aktivierten Kippluftlagern gegen das Substrat gefahren und danach zusätzlich über den Luftkanal 22 mit Druckluft beaufschlagt werden. Bei geeigneter Ausführung des Substrats 3 und der Aufnahmefläche 36 wird zwischen Substrat und der Aufnahmefläche des Werkzeugs dadurch ein weiteres flächiges Luftlager gebildet, sodass das Werkzeug praktisch reibungslos in der X-/Y-Ebene gleiten kann. Dadurch können geringe Translationsbewegungen des Aufnahmewerkzeugs in dieser Ebene frei stattfinden, die eventuell bei der planparallelen Ausrichtung des Aufnahmewerkzeugs zum Substrat in Folge von Verformungen der Werkzeughalterung 4 oder aller anderen Komponenten der Vorrichtung auftreten, wenn die Ausrichtung unter hoher Anpresskraft durchgeführt wird. Eine Ausrichtung unter hoher Anpresskraft kann sinnvoll sein, wenn im normalen Betrieb des Die-Bonders mit entsprechenden Kräften gearbeitet wird und die Planparallelität unter eben diesen Bedingungen gewährleistet werden soll. Durch diese Einstellmethode wird einerseits ein Verkanten des Aufnahmewerkzeugs auf dem Substrat und letztlich eine Fehleinstellung ausgeschlossen. Nach Beendigung des Einstellvorgangs werden die Kippluftlager wiederum wie bei Figur 2c blockiert, das Werkzeug vom Substrat zurückgezogen und schliesslich die Druckluftversorgung über den Luftkanal deaktiviert.

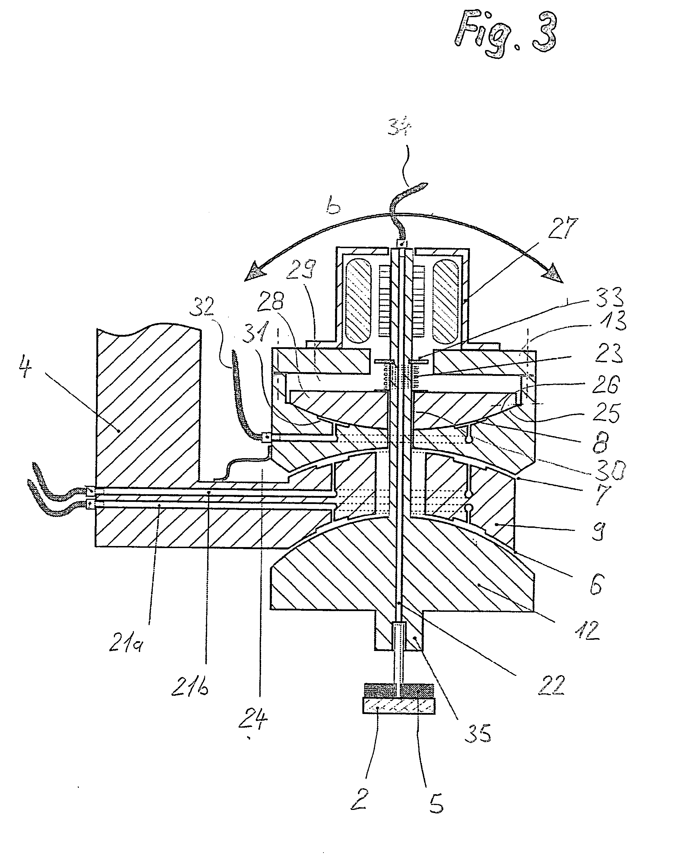

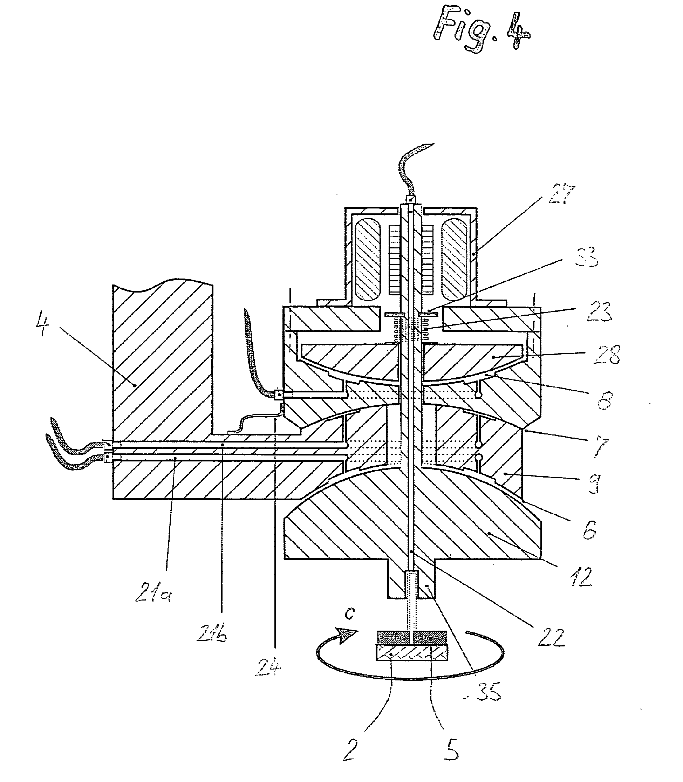

Anhand der Figuren 3 und 4 wird eine weitere Ausführungsform der erfindungsgemässen Vorrichtung beschrieben, bei welcher zusätzlich zu den beiden Kippluftlagern noch ein Rotationsluftlager zum reibungsfreien Drehen des Aufnahmewerkzeugs 5 vorgesehen ist. Gemäss Figur 3 sind die beiden Kippluftlager 6 und 7 sowie der erste Kipplagerkörper 12 praktisch gleich aufgebaut wie beim Ausführungsbeispiel gemäss Figur 1. Allerdings können die beiden Kippluftlager separat und unabhängig voneinander mit Druckluft beaufschlagt werden und zwar über die separaten Zufuhrleitungen 21a und 21b.

Der zweite Kipplagerkörper 13 verfügt zusätzlich über eine Rotationslagerfläche 25, über welcher ein Rotationslagerkörper 28 angeordnet ist. Die Führungsspindel 19 durchdringt nicht nur den zweiten Kipplagerkörper 13 sondern auch den Rotationslagerkörper 28 durch eine Öffnung 30. Die Rotationslagerfläche 25 bildet zusammen mit einer Rotationsgegenlagerfläche 26 am Rotationslagerkörper ein Rotationsluftlager 8.

Die Beaufschlagung des Rotationsluftlagers 8 mit Durchluft erfolgt über ein System aus Luftkanälen und Luftdüsen 31, die ebenfalls um die Öffnung 30 verteilt bzw. angeordnet sind. Die Zufuhr von Druckluft erfolgt über eine Zufuhrleitung 32.

Die Vorspannkraft zum Blockieren der verschiedenen Luftlager wird wiederum durch beispielsweise eine Schraubendruckfeder 23 aufgebracht, die an einem Spannring 33 an der Führungsspindel 19 abgestützt ist. Am anderen Ende liegt die Schraubendruckfeder auf dem Rotationslagerkörper 28, sodass dieser ersichtlicherweise gegen die Rotationslagerfläche 25 gepresst wird.

Über dem zweiten Kipplagerkörper 13 und starr mit diesem verbunden ist ein Rotationsantrieb 27 angeordnet. Dabei handelt es sich in der dargestellten Ausführung um einen elektrischen Direktantrieb dessen Rotor unmittelbar durch die Führungsspindel 19 gebildet wird. Denkbar sind aber auch eine Vielzahl anderer Antriebe und Übertragungen, mit denen sich eine Rotation der Spindel 19 relativ zum Kipplagerkörper 13 erreichen lässt. Mit Hilfe des Rotationsantriebs kann die Führungsspindel in Pfeilrichtung c (Figur 4) in beide Richtungen gedreht werden, sofern dieser Freiheitsgrad durch die weiter unten beschriebene Aktivierungskonfiguration der Luftlager freigegebenen wird. Der Stator des Rotationsantriebs ist beispielsweise auf eine Abschlussplatte montiert, welche auf dem zweiten Kipplagerkörper 13 ruht und beispielsweise mit diesem verschraubt ist. Dabei ergibt sich ersichtlicherweise ein Hohlraum 29, der den Rotationslagerkörper 28 vollständig umgibt.

Um ein Verdrehen des Kipplagerkörpers 13 gegenüber der Werkzeughalterung 4 zu vermeiden, ist eine Verdrehsicherung 24 vorgesehen, welche beispielsweise durch eine Blattfeder gebildet werden kann, die so ausgelegt ist, dass die Rückstellkraft von unerwünschten Rotationsauslenkungen erheblich höher als die Rückstellkräfte von Kippauslenkungen ist.

Der in Figur 3 dargestellte Betriebszustand entspricht im Wesentlichen demjenigen gemäss Figur 2a. Die beiden Kippluftlager 6 und 7 werden simultan über die Zufuhrleitungen 21a und 21b mit Druckluft beaufschlagt, sodass die gesamte Werkzeuganordnung zwar beispielsweise in Pfeilrichtung b gekippt, jedoch bei blockiertem Antrieb aufgrund der Verdrehsicherung 24 nicht gedreht werden kann. Das Rotationsluftlager 8 ist dagegen drucklos, sodass es unter Einwirkung der Schraubendruckfeder 23 blockiert ist.

Wird nun eine Rotation des Aufnahmewerkzeugs um seine Längsmittelachse gewünscht, wird die Vorrichtung gemäss Figur 4 betrieben. Dabei wird das zweite Kippluftlager 7 durch Unterbrechung der Luftzufuhr an der Zufuhrleitung 21b deaktiviert, sodass der zweite Kipplagerkörper 13 gegen die Lagerplatte 9 gepresst wird und eine Kippbewegung nicht mehr möglich ist. Dagegen wird der Luftdruck am ersten Kippluftlager 6 aufrecht erhalten, sodass sich der erste Kipplagerkörper 12 zusammen mit der Führungsspindel 19 und dem Aufnahmewerkzeug 5 nach wie vor drehen kann.

Für die Drehbewegung ist es jedoch erforderlich, das Rotationsluftlager 8 über die Zufuhrleitung 32 mit Druckluft zu beaufschlagen, wodurch der Rotationslagerkörper 28 freigestellt wird. Jetzt kann über den Rotationsantrieb 27 die gewünschte Drehposition des Aufnahmewerkzeugs bzw. des zu platzierenden Bauteils relativ zum arretierten Kipplagerkörper 13 und somit auch relativ zur Werkzeughalterung 4 eingestellt werden. Diese Konfiguration entspricht dem typischen Betriebszustand des Die-Bonders, in dem bei voreingestellter Planparallelität das Absetzen der Bauteil unter individueller Rotationskorrektur stattfindet. Bei Bedarf werden auch das erste Kippluftlager 6 und das Rotationsluftlager 8 deaktiviert bzw. blockiert, sodass die gewünschte Kipplage und die gewünschte Drehlage fest eingestellt bleiben.

Das Rotationsluftlager 8 ist beim vorliegenden Ausführungsbeispiel gegensinnig sphärisch zum Kippluftlager 6 ausgeführt, weil beide Lager zur Rotation des Werkzeugs erforderlich sind und sich auf diese Weise eine optimale Achsstabilität erreichen lässt. Gleichzeitig ist diese Ausführung nicht anfällig auf relative Fertigungstoleranzen der beiden Lager. In bestimmten Anwendungsfällen könnte das Rotationsluftlager 8 aber auch beispielsweise als planes oder kegelförmiges Lager ausgebildet sein.

Selbstverständlich ist es ohne weiteres denkbar, dass die Positionierung der Kipplage und der Drehlage nicht nacheinander, sondern gleichzeitig erfolgen. In einem derartigen Fall werden die beiden Kippluftlager 6 und 7 und das Rotationsluftlager 8 gleichzeitig mit Druckluft beaufschlagt, sodass ein Kippen und Drehen des Werkzeugs simultan möglich ist. Es sind ausserdem erfindungsgemässe Vorrichtungen denkbar, die ausschliesslich über ein Rotationsluftlager verfügen. In einem derartigen Fall wäre ersichtlicherweise überhaupt kein Kippen des Werkzeugs möglich.

## Patentansprüche

1. Vorrichtung (1) zum Positionieren und/oder Anpressen eines flächigen Bauteils (2) relativ zu einem Substrat (3), insbesondere für einen Die-Bonder, mit einem an einer Werkzeughalterung (4) angeordneten und in vorzugsweise mehreren Freiheitsgeraden beweglichen Aufnahmewerkzeug (5), **dadurch gekennzeichnet, dass** das Aufnahmewerkzeug (5) über wenigstens ein mit Druckluft beaufschlagbares Luftlager (6, 7, 8) direkt oder indirekt an der Werkzeugshalterung (4) gelagert ist, wobei die Lagerposition am Luftlager im drucklosen Zustand unter Vorspannkraft fixierbar ist.

2. Vorrichtung nach Anspruch 1, **dadurch gekennzeichnet, dass** das Aufnahmewerkzeug (5) an zwei sphärischen, konzentrischen Kippluftlagern (6, 7) gelagert ist, wobei an beiden Seiten einer der Werkzeughalterung (4) zugeordneten, sphärischen Lagerplatte (9) mit gleichsinnig gekrümmten Kipplagerflächen (10, 11) je ein erster und ein zweiter Kipplagerkörper (12, 13) mit je einer korrespondierenden Kippgegenlagerfläche (14, 15) angeordnet ist, wobei die beiden Kipplagerkörper unter Vorspannkraft gegen einander bzw. gegen die Lagerplatte pressbar sind.

3. Vorrichtung nach Anspruch 2, **dadurch gekennzeichnet, dass** das Drehzentrum (16) der beiden sphärischen Kippluftlager (6, 7) in der Aufnahmeebene (17) des Aufnahmewerkzeugs (5) und vorzugsweise auf dem geometrischen Mittelpunkt der Aufnahmefläche (36) des Aufnahmewerkzeugs liegt.

4. Vorrichtung nach Anspruch 2 oder 3, **dadurch gekennzeichnet, dass** die Lagerplatte (9) eine zentrale Öffnung (18) aufweist und dass einer der beiden Kipplagerkörper (12) eine die Öffnung durchdringende Führungsspindel (19) aufweist, an welcher der benachbarte Kipplagerkörper (13) unter Vorspannung gelagert ist, wobei der Innendurchmesser der zentralen Öffnung und der Aussendurchmesser der Führungsspindel so dimensioniert sind, dass das Aufnahmewerkzeug (5) in alle Richtungen um ein begrenztes Mass kippbar ist.

5. Vorrichtung nach Anspruch 4, **dadurch gekennzeichnet, dass** um die zentrale Öffnung (18) auf beiden Kipplagerflächen (10, 11) der sphärischen Lagerplatte (9) an der Oberfläche verlaufende Luftkanäle (20) angeordnet sind, welche an eine Druckluftquelle anschliessbar sind.

6. Vorrichtung nach Anspruch 4 oder 5, **dadurch gekennzeichnet, dass** die Führungsspindel (19) eine Hohlspindel ist, durch welche ein Luftkanal (22) zum Beaufschlagen des Aufnahmewerkzeugs (5) mit einem Unterdruck oder einem Überdruck geführt ist.

7. Vorrichtung nach einem der Ansprüche 4 bis 6, **dadurch gekennzeichnet, dass** an der Führungsspindel (19) ein Federelement (23) zum Vorspannen der beiden Kipplagerkörper (12, 13) gegen einander bzw. gegen die sphärische Lagerplatte (9) gelagert ist.

8. Vorrichtung nach einem der Ansprüche 1 bis 7, **dadurch gekennzeichnet, dass** für die Fixierung der Lagerposition am Luftlager vorzugsweise steuerbare hydraulische oder pneumatische Vorspannmittel angeordnet sind.

9. Vorrichtung nach einem der Ansprüche 2 bis 8, **dadurch gekennzeichnet, dass** zwischen wenigstens einem Kipplagerkörper (13) und der Werkzeughalterung (4) eine Verdrehsicherung (24) angeordnet ist, welche ein Verdrehen des Aufnahmewerkzeugs (5) relativ zur Lagerplatte verhindert, jedoch eine Kippbewegung erlaubt.

10. Vorrichtung nach einem der Ansprüche 2 bis 9, **dadurch gekennzeichnet, dass** an einem der beiden Kipplagerkörper (12, 13) ein Rotationsluftlager (8) angeordnet ist, das eine dem betreffenden Kipplagerkörper (13) zugeordnete Rotationslagerfläche und eine an einem Rotationslagerkörper (28) angeordnete Rotationsgegenlagerfläche (26) aufweist, wobei der Rotationslagerkörper unter Vorspannung am gegenüberliegenden Kipplagerkörper (12) gelagert ist und wobei durch Beaufschlagung des Rotationsluftlagers (8) und eines der beiden Kippluftlager (6) mit Druckluft das Aufnahmewerkzeug (5) um seine Längsmittelachse (37) drehbar ist.

11. Vorrichtung nach Anspruch 10, **dadurch gekennzeichnet, dass** das Aufnahmewerkzeug über einen vorzugsweise elektrischen Rotationsantrieb (27) drehantreibbar ist.

12. Vorrichtung nach Anspruch 11, **dadurch gekennzeichnet, dass** der Rotationsantrieb (27( über dem Rotationslagerkörper (28) lösbar an dem das Rotationsluftlager (8) tragenden Kipplagerkörper (13) befestigt ist.

13. Vorrichtung nach Anspruch 4 und einem der Ansprüche 10 bis 12, **dadurch gekennzeichnet, dass** der Rotationslagerkörper (28) eine zentrale Öffnung (30) aufweist, an der er an der Führungsspindel (19) geführt ist.

14. Vorrichtung nach einem der Ansprüche 10 bis 13, **dadurch gekennzeichnet, dass** die beiden sphärischen Kippluftlager (6, 7) an der sphärischen Lagerplatte (9) über separate Druckluftleitungen (21a, 21b) beaufschlagbar sind und dass der das Rotationsluftlager (8) tragende Kipplagerkörper (13) an der Lagerplatte (9) arretierbar ist, sodass bei einer Druckbeaufschlagung des Rotationsluftlagers (8) und des Kippluftlagers (6) am gegenüberliegenden Kipplagerkörper (12) nur letzterer um seine Achse drehbar ist.

15. Vorrichtung nach einem der Ansprüche 10 bis 14, **dadurch gekennzeichnet, dass** die axiale Vorspannung der Kipplagerkörper (12, 13) gegeneinander sowie des Rotationslagerkörpers (28) gegen den einen Kipplagerkörper (13) mit dem gleichen Vorspannmittel (23) erfolgt.

16. Vorrichtung nach einem der Ansprüche 2 bis 15, **dadurch gekennzeichnet, dass** die Kippposition des Aufnahmewerkzeugs (5) bei gelösten Kippluftlagern (6, 7) durch eine Einstellvorrichtung (38) einstellbar ist.

17. Verfahren zum Positionieren eines Aufnahmewerkzeugs (5) relativ zu einem Substrat (3), welches Aufnahmewerkzeug an einer Werkzeughalterung (4) angeordnet und in vorzugsweise mehreren Freiheitsgraden beweglich gelagert ist, insbesondere an einem Die-Bonder, **dadurch gekennzeichnet, dass** die Lagerung über wenigstens ein mit Luftdruck beaufschlagbares Luftlager erfolgt, wobei die Positionierung im aktivierten Zustand des Luftlagers erfolgt und wobei nach dem Abbau des Luftdrucks die Lagerstelle infolge einer durch eine Vorspannkraft erzeugten Reibung arretiert wird.

18. Verfahren nach Anspruch 17, **dadurch gekennzeichnet, dass** das Aufnahmewerkzeug (5) zum Positionieren um einen Drehpunkt (16) gekippt wird und/oder um eine Längsmittelachse (37) gedreht wird.

19. Verfahren nach einem der Ansprüche 17 oder 18, **dadurch gekennzeichnet, dass** die Positionierung in eine Kippstellung durch Anpressen des Aufnahmewerkzeugs gegen ein Substrat oder gegen eine Lehre erfolgt, dass das Luftlager im angepressten Zustand deaktiviert wird und dass die Lagerstelle vor dem Abheben des Aufnahmewerkzeugs arretiert wird.

## Claims

1. A device (1) for positioning and/or pressing on a planar component (2) relative to a substrate (3), in particular for a die bonder, with a picking tool (5) that is arranged on a tool support (4) and preferably movable in several degrees of freedom, **characterized in that** the picking tool (5) is mounted directly or indirectly in the tool support (4) via at least one air bearing (6, 7, 8) that can be applied with compressed air, wherein the mounting position on the air bearing can be fixed in the non-pressurized condition using a pretensioning force.

2. The device according to claim 1, **characterized in that** the picking tool (5) is mounted on two spherical, concentric pivoting air bearings (6, 7), wherein both sides of a spherical bearing plate (9) that is allocated to the tool support (4) and has pivoting bearing surfaces (10, 11) curved in the same direction accommodate a first and second pivoting bearing body (12, 13) each with a corresponding counter-bearing surface (14, 15), wherein the two pivoting bearing bodies can be pressed against each other or against the bearing plate using a pretensioning force.

3. The device according to claim 2, **characterized in that** the rotational center (16) of the two spherical pivoting air bearings (6, 7) lie in the receiving plane (17) of the picking tool (5), and preferably on the geometric midpoint of the receiving surface (36) of the picking tool.

4. The device according to claim 2 or 3, **characterized in that** the bearing plate (9) has a central opening (18), and that one of the two pivoting bearing bodies (12) has a guiding spindle (19) that penetrates through the opening, having mounted to it the adjacent pivoting bearing body (13) in a pretensioned manner, wherein the inner diameter of the central opening and the outer diameter of the guiding spindle are dimensioned in such a way that the picking tool (5) can be pivoted in all directions to a limited extent.

5. The device according to claim 4, **characterized in that** air channels (20) running on the surface are arranged around the central opening (18) on both pivoting bearing surfaces (10, 11) of the spherical bearing plate (9), and can be connected to a compressed air source.

6. The device according to claim 4 or 5, **characterized in that** the guiding spindle (19) is a hollow spindle, through which is guided an air channel (22) for exposing the picking tool (5) to an underpressure or overpressure.

7. The device according to one of claims 4 to 6, **characterized in that** the guiding spindle (19) accommodates a spring element (23) for pretensioning the two pivoting bearing bodies (12, 13) against each other or against the spherical bearing plate (9).

8. The device according to one of claims 1 to 7, **characterized in that** preferably controllable hydraulic or pneumatic pretensioning means are arranged on the air bearing to fix the bearing position.

9. The device according to one of claims 2 to 8, **characterized in that** a torsional safeguard (24) is arranged between at least one pivoting bearing body (13) and the tool support (4), so as to prevent the picking tool (5) from twisting relative to the bearing plate, while permitting a pivoting motion.

10. The device according to one of claims 2 to 9, **characterized in that** one of the two pivoting bearing bodies (12, 13) accommodates a rotational air bearing (8), which has a rotational bearing surface allocated to the respective pivoting bearing body (13) and a rotational counter-bearing surface (26) arranged on a rotational bearing body (28), wherein the rotational bearing body is pretensioned and mounted on the opposite pivoting bearing body (12), and wherein the picking tool (5) can be rotated around its longitudinal central axis (37) by exposing the rotational air bearing (8) and one of the two pivoting air bearings (6) to compressed air.

11. The device according to claim 10, **characterized in that** the picking tool can be rotationally driven by means of a preferably electrical rotational drive (27).

12. The device according to claim 11, **characterized in that** the rotational bearing body (28) detachably secures the rotational drive (27) to the pivoting bearing body (13) carrying the rotational air bearing (8).

13. The device according to claim 4 and one of claims 10 to 12, **characterized in that** the rotational bearing body (28) has a central opening (30) via which it is guided on the guiding spindle (19).

14. The device according to one of claims 10 to 13, **characterized in that** the two spherical pivoting air bearings (6, 7) can be pressurized on the spherical bearing plate (9) via separate compressed air lines (21a, 21b), and that the pivoting bearing body (13) carrying the rotational air bearing (8) can be locked on the bearing plate (9), so that when the rotational air bearing (8) and the pivoting air bearing (6) on the opposite pivoting bearing body (12) are pressurized, only the latter can rotate around its axis.

15. The device according to one of claims 10 to 14, **characterized in that** the same pretensioning means are used to axially pretension the pivoting bearing bodies (12, 13) relative to each other and the rotational bearing body (28) relative to the one pivoting bearing body (13).

16. The device according to one of claims 2 to 15, **characterized in that** an adjusting device (38) can be used to adjust the pivoting position of the picking tool (5) with the pivoting air bearings (6, 7) detached.

17. A method for positioning a picking tool (5) relative to a substrate (3), wherein the picking tool is arranged on a tool support (4), preferably movable in multiple degrees of freedom, in particular on a die bonder, **characterized in that** mounting takes place via at least one air bearing exposable to air pressure, wherein positioning takes place in the activated condition of the air bearing, and wherein the bearing location is locked in place after the air pressure has been relieved as the result of a friction generated by a pretensioning force.

18. The method according to claim 17, **characterized in that** the picking tool (5) is pivoted around a fulcrum (16) and/or turned around a longitudinal central axis (37) for positioning purposes.

19. The method according to one of claims 17 or 18, **characterized in that** positioning in a pivoting position takes place by pressing the picking tool against a substrate or against a template, that the air bearing is deactivated in the pressed condition, and that the bearing location is locked in place before the picking tool is lifted off.

## Revendications

1. Dispositif (1) pour positionner et/ou comprimer un élément plat (2) par rapport à un substrat (3), en particulier pour une microsoudeuse de puce, comprenant un outil de réception (5) placé sur une fixation d'outil (4) et mobile dans plusieurs degrés de liberté de préférence, **caractérisé en ce que** l'outil de réception (5) est placé directement ou indirectement sur la fixation d'outil (4) par au moins un palier à air (6, 7, 8) pouvant être alimenté en air comprimé, sachant que la position d'appui sur le palier à air peut être fixée par une force de précontrainte en état de pression nulle.

2. Dispositif selon la revendication 1, **caractérisé en ce que** l'outil de réception (5) est placé sur deux paliers à air à bascule (6, 7) sphériques et concentriques, sachant qu'un premier et un deuxième corps de palier à bascule respectifs (12, 13) avec une surface de contre-palier à bascule correspondante (14, 15) sont placés sur les deux côtés d'un plateau de palier (9) sphérique attribué à la fixation d'outil (4) avec des surfaces de palier à bascule (10, 11) courbées dans le même sens, sachant que les deux corps de palier à bascule peuvent être comprimés l'un contre l'autre respectivement contre le plateau de palier par la force de précontrainte.

3. Dispositif selon la revendication 1, **caractérisé en ce que** le centre de rotation (16) des deux paliers à air à bascule (6, 7) sphériques repose dans le plan de réception (17) de l'outil de réception (5) et de préférence sur le centre géométrique de la surface de réception (36) de l'outil de réception.

4. Dispositif selon la revendication 2 ou 3, **caractérisé en ce que** le plateau de palier (9) présente une ouverture centrale (18) et que l'un des deux corps de palier à bascule (12) présente une tige de guidage (19) traversant l'ouverture, sur laquelle le corps de palier à bascule voisin (13) est placé par précontrainte, sachant que le diamètre intérieur de l'ouverture centrale et le diamètre extérieur de la tige de guidage sont ainsi dimensionnés que l'outil de réception (5) est basculable dans toutes les directions et dans une dimension délimitée.

5. Dispositif selon la revendication 4, **caractérisé en ce que** des canaux d'air (20) se profilant sur la surface, autour de l'ouverture centrale (18) sur les deux surfaces de palier à bascule (10, 11) du plateau de palier (9) sphérique, sont prévus, lesquels peuvent être raccordés à une source d'air comprimé.

6. Dispositif selon la revendication 4 ou 5, **caractérisé en ce que** la tige de guidage (19) est une tige creuse à travers laquelle un canal d'air (22) est dirigé pour alimenter l'outil de réception (5) en sous-pression ou en sur-pression.

7. Dispositif selon l'une des revendications 4 à 6, **caractérisé en ce qu'**un élément élastique est placé sur la tige de guidage (19) pour précontraindre les deux corps de palier à bascule respectifs (12, 13) l'un contre l'autre respectivement contre le plateau de palier (9) sphérique.

8. Dispositif selon l'une des revendications 1 à 7, **caractérisé en ce que** des moyens de précontrainte pouvant être commandés de préférence de manière hydraulique ou pneumatique sont placés pour fixer la position d'appui sur le palier à air.

9. Dispositif selon l'une des revendications 2 à 8, **caractérisé en ce qu'**entre au moins un corps de palier à bascule (13) et la fixation d'outil (4), une sécurité anti-rotation (24) est placée qui empêche une rotation de l'outil de réception(5) par rapport au plateau de palier mais permet toutefois un basculement.

10. Dispositif selon l'une des revendications 2 à 9, **caractérisé en ce qu'**un palier à air de rotation (8) est placé sur l'un des deux corps de palier à bascule (12, 13), lequel présente une surface de palier de rotation correspondant au corps de palier à bascule (13) concerné et une surface de contre-palier de rotation (26) correspondant à un corps de palier de rotation (28), sachant que le corps de palier de rotation est placé par précontrainte sur le corps de palier à bascule (12) opposé, et sachant que par l'alimentation en air comprimé du palier à air de rotation (8) et de l'un des paliers à air à bascule (6), l'outil de réception (5) peut tourner sur son axe médian longitudinal (37).

11. Dispositif selon la revendication 10, **caractérisé en ce que** l'outil de réception peut être entraîné en rotation par un entraînement en rotation (27) de préférence électrique.

12. Dispositif selon la revendication 11, **caractérisé en ce que** l'entraînement en rotation (27) est fixé sur le corps de palier à bascule (13) supportant le palier à air de rotation (8) en étant séparable par le corps de palier de rotation (28).

13. Dispositif selon la revendication 4 et l'une des revendications 10 à 12, **caractérisé en ce que** le corps de palier de rotation (28) présente une ouverture centrale (30) sur laquelle il est dirigé sur la tige de guidage (19).

14. Dispositif selon l'une des revendications 10 à 13, **caractérisé en ce que** les deux paliers à air à bascule (6, 7) sphériques sur le plateau de palier sphérique (9) peuvent être alimentés par des conduites d'air comprimé (21a, 21b) séparées et **en ce que** le corps de palier à bascule (13) supportant le palier à air de rotation (8) peut être bloqué sur le plateau de palier (9), de façon à ce que lorsque le palier à air de rotation (8) et le palier à air à bascule (6) sont alimentés en air comprimé sur le corps de palier à bascule (12) opposé, seul le dernier peut tourner sur son axe.

15. Dispositif selon l'une des revendications 10 à 14, **caractérisé en ce que** la précontrainte axiale des corps de palier à bascule (12, 13) l'un contre l'autre ainsi que celle du corps de palier de rotation (28) contre l'un corps de palier à bascule (13) s'effectue avec le même moyen de précontrainte (23).

16. Dispositif selon l'une des revendications 2 à 15, **caractérisé en ce que** la position de bascule de l'outil de réception (5) peut être réglée par un dispositif de réglage (38) lorsque les paliers à air à bascule (6, 7) sont détachés.

17. Procédé de positionnement d'un outil de réception (5) par rapport à un substrat (3), lequel outil de réception est placé sur une fixation d'outil (4) et mobile dans plusieurs degrés de liberté de préférence, en particulier sur une microsoudeuse de puce, **caractérisé en ce que** l'appui s'effectue par au moins un palier à air pouvant être alimenté en air comprimé, sachant que le positionnement s'effectue lorsque le palier à air est en état activé et sachant qu'après la réduction de la pression, la position du palier est bloquée à la suite d'un frottement produit par une force de précontrainte.

18. Procédé selon la revendication 17, **caractérisé en ce que** l'outil de réception (5) est basculé sur un point de rotation (16) et/ou est tourné sur un axe médian longitudinal (37) pour le positionnement.

19. Procédé selon l'une des revendications 17 ou 18, **caractérisé en ce que** le positionnement dans une position de bascule s'effectue par une compression de l'outil de réception contre un substrat ou contre un gabarit, que le palier à air est désactivé à l'état comprimé et que la position d'appui est bloquée avant que l'outil de réception ne soit levé.
